(19) **Europäisches Patentamt**

**European Patent Office**

**Office européen des brevets**

(11) **EP 1 594 238 A2**

(12) **EUROPEAN PATENT APPLICATION**

(43) Date of publication:
09.11.2005 Bulletin 2005/45

(51) Int Cl.$^7$: **H04B 10/155**

(21) Application number: 05300357.0

(22) Date of filing: 04.05.2005

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **06.05.2004 US 569309 P**

(71) Applicant: **Avanex Corporation**
**Fremont, CA 94538 (US)**

(72) Inventors:
- **Volz, Leroy**
  **La Quinta, CA 92253 (US)**
- **Phan, Duc T.**
  **Saratoga, CA 95070-5013 (US)**
- **Li, Wenjun**
  **Fremont, CA 94539 (US)**

(74) Representative: **Feray, Valérie et al**
**Feray Lenne Conseil**
**39/41, avenue Aristide Briand**
**92163 Antony (FR)**

(54) **Method and system for controlling laser diodes in optical communications systems**

(57)     A system and an apparatus used to control laser diodes in optical communications systems, wherein the targeted or desired laser power can be varied, if needed, as a function of the laser temperature, and/or any other pertinent parameters. The adjustment of the targeted laser power or of the laser modulation current, via analog signals provided by digital-to-analog converters (DAC's), may be implemented either as a table lookup or as an explicit equation of one or more variables. If implemented as an explicit equation, the curve fit used to generate the equation may be any order.

**EP 1 594 238 A2**

**Description**

**CROSS-REFERENCE TO RELATED APPLICATIONS**

This application claims benefit of United States provisional patent application serial number 60/569,309, filed May 6, 2004, which is herein incorporated by reference.

## FIELD OF THE INVENTION

The present invention relates to laser light sources utilized in optical transmitters, transceivers and transponders of optical communications systems. More particularly, the present invention relates to methods and systems for accurately controlling laser power and extinction ratio under the effects of external temperature disturbances, aging, and large variations in back-facet diode responsivity.

## BACKGROUND OF THE INVENTION

Transmitter laser diodes are used in applications such as fiber-optical transponder or transceiver modules to transmit data at high rates. The extinction ratio, modulation, and average power of such a laser (e. g., directly modulated lasers) is too sensitive to aging and is also sensitive to external effects such as changes in environmental temperature. Even with closed-loop control systems to servo the average laser power, it is still difficult to minimize the variation of extinction ratio and eye crossing (i.e., on a bit-error diagram) due to changes in environmental temperature. Further complicating the technical issues is the large variation in back-facet diode responsivity, measured in mA of back facet diode monitor current per mW of optical output power.

Prior art solutions to these problems involve measuring or calibrating the laser diode optical output power as a function of the laser bias current. Output power is typically measured using a back facet diode monitor whose current is piece-wise proportional to the laser output power. Once this transfer curve is known, the settings for average power, modulation, and extinction ratio can be determined. The drawback of this approach is that over time, due to aging, this transfer function needs to be regenerated. It is typically carried out whenever the unit is powered up or whenever the system is idle. There are two drawbacks to these prior-art approaches. Firstly, if the transfer curve needs to be measured every time the unit is powered up or upon power on reset, the time required to start the unit is increased. Secondly, if the transfer curve needs to be measured periodically to handle aging effects then it will cause disruption of normal operation, since the calibration of the laser power vs. bias current curve precludes the normal operation of the laser diode.

The prior-art approaches typically require the calibration of the laser power vs. the bias current transfer curve. Thus, these prior-art approaches cause an increase in the time required for the unit to be ready and can cause disruption of normal transmitter operation to calibrate the laser power vs. bias current transfer curve. Both of these effects are undesirable.

## SUMMARY OF THE INVENTION

To overcome the above-described drawbacks with conventional apparatuses and methods, there is herein disclosed an improved system and apparatus for controlling laser diodes in optical communications systems, wherein the targeted or desired laser power can be varied, if needed, as a function of the laser temperature, and/or any other pertinent parameters. The adjustment of the targeted laser power or of the laser modulation current, via analog signals provided by digital-to-analog converters (DAC's), may be implemented either as a table lookup or as an explicit equation of one or more variables. If implemented as an explicit equation, the curve fit used to generate the equation may be any order.

An important novel and useful feature of a system in accordance with the present invention is implementation, entirely within the firmware a microprocessor (or micro controller) control system for closed-loop control for maintaining constant average laser power. Firmware may also be used to implement a look up table or a curve fit for setting up an initial laser bias current as a function of the laser temperature. This utilization of firmware improves the laser output power response and settling time.

Further, a system in accordance with the present invention may use a digital potentiometer or a gain switch circuit to calibrate the large variation in back facet diode responsivity (mA/mW), the calibration preferably being performed either by firmware in the microprocessor or by test software. There is no need to calibrate the laser transmitter system (which may be part of a Transmitter Optical Sub-Assembly) while in operation, thus it is not necessary to delay the time for the system to be ready nor to interrupt the system operation to carry out any calibration.

A first preferred embodiment of a system in accordance with the present invention comprises a microprocessor to implement the average laser power servo and the control algorithms, at least one analog-to-digital converter (ADC) electrically coupled to and delivering a digital signal to a signal input of the microprocessor, at least two digital-to-analog converters (DAC's) electrically coupled to and receiving respective digital signals from signal outputs of the microprocessor, an optical transmitter module electrically coupled to the DAC's, the optical transmitter module including a laser diode having a back-facet photo-detector, sensor-signal conditioning circuitry electrically coupled to the back-facet photo-detector, and a multiplexer electrically coupled to between the sensor-signal conditioning circuitry and the at least on ADC.

## BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

FIG. 1 is a schematic illustration of a preferred embodiment of a closed-loop laser controller system in accordance with the present invention;

FIG. 2 is a flow diagram of a first preferred method, in accordance with the present invention, for controlling a laser light source for maintaining constant average laser power;

FIG. 3 is a flow diagram of a second preferred method, in accordance with the present invention, for controlling a laser light source for maintaining constant average laser power;

FIG. 4A is a flow diagram of a third preferred method, in accordance with the present invention, for controlling a laser light source, said method being directed to calibrating large variation of the back-facet diode current;

FIG. 4B is a flow diagram of a detailed variation of a portion of the method of FIG. 4A; and

FIG. 5 is a graph of the back facet monitor voltage vs. back facet diode current wherein the overall response consists of two portions, each portion having a respective slope of voltage vs. current.

## DETAILED DESCRIPTION OF THE PREFERRED EMBODIMENTS

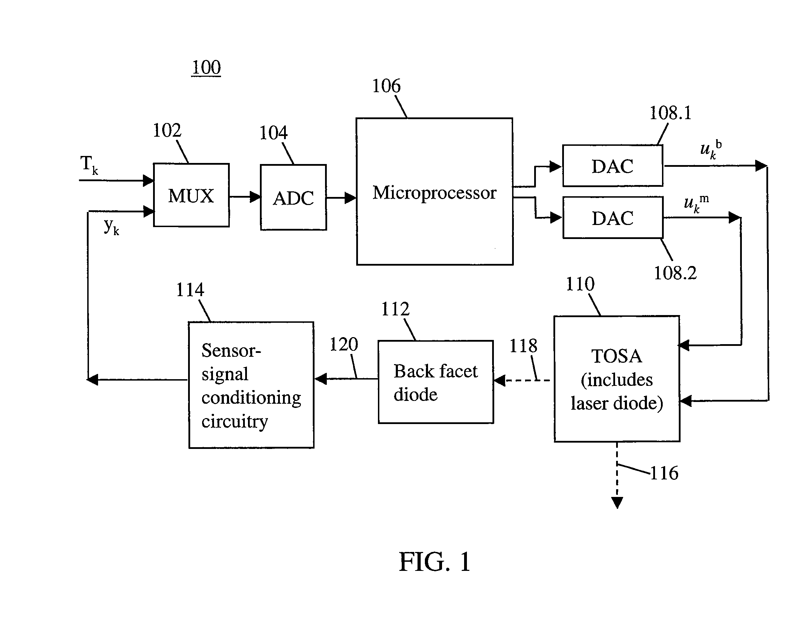

The present invention provides an improved system and method for control of laser diodes in optical communications systems. The following description is presented to enable one ordinary skilled in the art to make and use the invention and is provided in the context of a patent application and its requirements. Various modifications to the preferred embodiments will be readily apparent to those skilled in the art and the generic principles described herein may be applied to other embodiments. Thus, the present invention is not intended to be limited to the embodiments shown, but is to be accorded the widest scope consistent with the principles and features described herein. In order to gain a detailed understanding of the invention, the reader is referred to the appended FIGS. 1-5 in conjunction with the following description. It is to be understood that the drawings are diagrammatic and schematic representations only and are neither limiting of the scope of the present invention nor necessarily drawn to scale.

FIG. 1 provides a simplified block diagram of a preferred embodiment of a laser controller system 100 in accordance with the present invention. The reader should note that solid arrows and dashed arrows are used in FIG. 1 to denote electrical signals and optical signals, respectively. The controller system 100 for controlling the laser diode transmitter comprises a microprocessor 106 (or micro controller) to implement the average laser power servo and the control algorithms described herein. The microprocessor 106 is normally already required and is already present (in a conventional system) to implement the software interface to a host computer, e.g. I2C serial interface and, thus, is not an added expense to implement within the present invention. The controller system 100 further comprises at least one analog-to-digital converter (ADC) 104 electrically coupled to and delivering a digital signal to a signal input of the microprocessor 106. The controller system 100 further comprises at least two digital-to-analog converters (DAC's) 108.1, 108.2, etc. electrically coupled to and receiving respective digital signals from signal outputs of the microprocessor 106. The ADC is electrically coupled to and receives analog signals from a multiplexer (MUX) 102.

The DAC's 108.1-108.2 within the controller system 100 (FIG. 1) are both electrically coupled to an optical transmitter module 110 hat may be a Transmitter Optical Sub-Assembly (TOSA) within an industry-standard SFP or XFP opto-electronic module. The transmitter module includes a laser diode to generate optical signals. Although the optical transmitter module is described herein as a TOSA, it may, alternatively be a simple optical transmitter, an optical transceiver or an optical transponder. The DAC 108.1 delivers, to the optical transmitter module 110, an analog signal, $u_k^b$, that is used to control the laser bias current. The DAC 108.2 delivers, to the optical transmitter module 110, an analog signal, $u_k^m$ that is used to control the laser modulation current.

In normal operation of the optical transmitter module 110 within an optical communications system (not shown), a laser diode of the module 110 outputs through its front facet an information-bearing optical signal 116 that is transmitted over optical fiber to another location of the optical communications system. Simultaneously, the laser diode outputs a small sample proportion 118 of the optical signal through its back facet. As is conventional in laser diodes, the sample proportion 118 is detected by a back facet diode 112 that is optically coupled to the laser diode of the optical transmitter module 110. Within the controller system 100 of the present invention, the electrical current output (i.e., the sensor signal) 120 from the back facet diode 112 is received by sensor-signal conditioning circuitry 114 that is electrically coupled to the back facet diode 112. The sensor-signal conditioning circuitry 114 produces an analog electrical signal $y_k$ whose voltage level is proportional to the power of the sample proportion 118 and, hence, to the optical signal 116. Preferably, the sensor-signal conditioning circuitry may include either a digital potentiometer or a gain switching circuit.

The sensor-signal conditioning circuitry 114 within the controller system 100 (FIG. 1) is electrically coupled to and delivers the analog electrical signal $y_k$ to the MUX 102. The MUX receives the analog electrical signal $y_k$ at one input and also receives, at another input, a second analog signal $T_k$ whose level is proportional to the laser temperature and that may be derived from a temperature sensor (not shown) physically coupled to the laser diode. Throughout this document, a mathematical symbol, such as the symbols $y_k$ and $T_k$, that contains the index subscript k (k=O, 1 ,2, ...) refers to a measurement obtained at a time $t_k$. The variable $t_k$, which is an independent time variable, assumes discrete values related to the sampling period.

The following paragraphs will now describe various embodiments of methods, in accordance with the present invention, of closed-loop control for maintaining constant average laser power, these methods being entirely implemented within the firmware of a microprocessor (or micro controller), such as, preferably, the microprocessor 106 of the system 100. No ASIC is required to implement the servo.

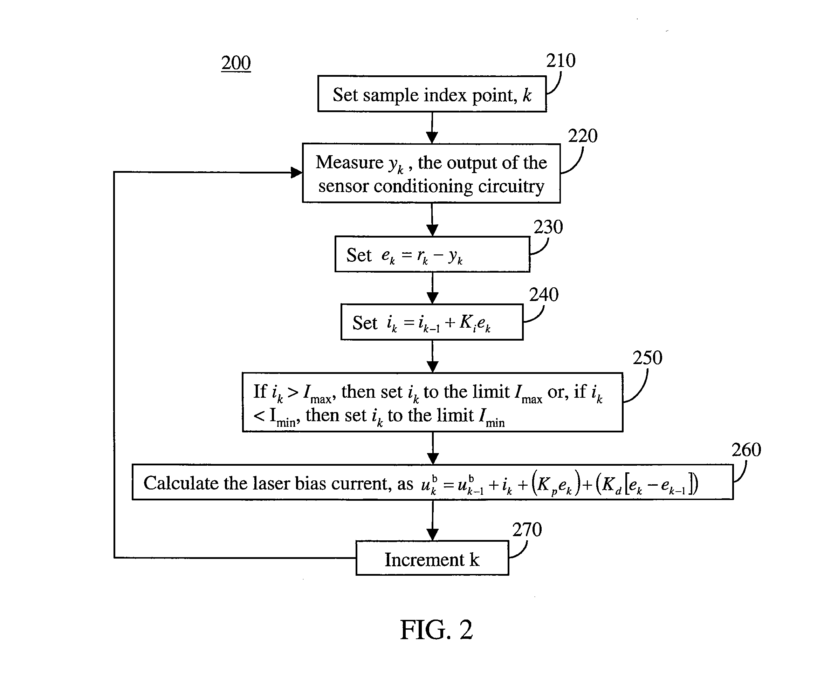

A first method 200, in accordance with the present invention, of closed-loop control for maintaining constant average laser power is now described. The method 200 comprises an algorithm that is schematically illustrated in FIG. 2 and that is described in further detail in the following sentences. Let $r_k$ denote the targeted or desired average laser power at the $k^{th}$ time sample point, that is, at time $t_k$. Further, let $y_k$ denote the output of the sensor-signal conditioning circuitry, let $u_k^b$ denote the laser bias current output from the DAC, and let $u_k^m$ denote the modulation current output from the DAC. In the first step 210 of the method 200 (FIG. 2) for closed-loop control of the average laser power, the sample index $k$ is set. Next, the method 200 proceeds to the step 220, wherein $y_k$, the output of the sensor-signal conditioning circuitry, is measured. Subsequently, the following steps are performed, in sequence (FIG. 2):

Step 230—Set $e_k = r_k - y_k$ wherein $e_k$ is the calculated error between the desired average power and the measured average power

Step 240—Set interim calculated current $i_k = i_{k-1} + K_i e_k$ wherein $K_i$ is the integral gain of the controller system

Step 250—If $i_k > I_{max}$, then set $i_k$ to the limit $I_{max}$ (maximum allowable limit) or, if $i_k < I_{min}$, then set $i_k$ to the limit $I_{min}$ (minimum allowable limit)

Step 260—Calculate the laser bias current, $u_k^b$, using the following expression

$$u_k^b = u_{k-1}^b + i_k + (K_p e_k) + (K_d[e_k - e_{k-1}])$$

In step 260, $K_p$ is the proportional gain of the controller system and $K_d$ is the derivative gain of the controller system. The method 200 proceeds from step 260 to step 270, in which the index variable $k$ is incremented. Finally, the method 200 passes from step 270 back to step 220 and the sequence of steps 220-270 are iterated repeatedly as described above.

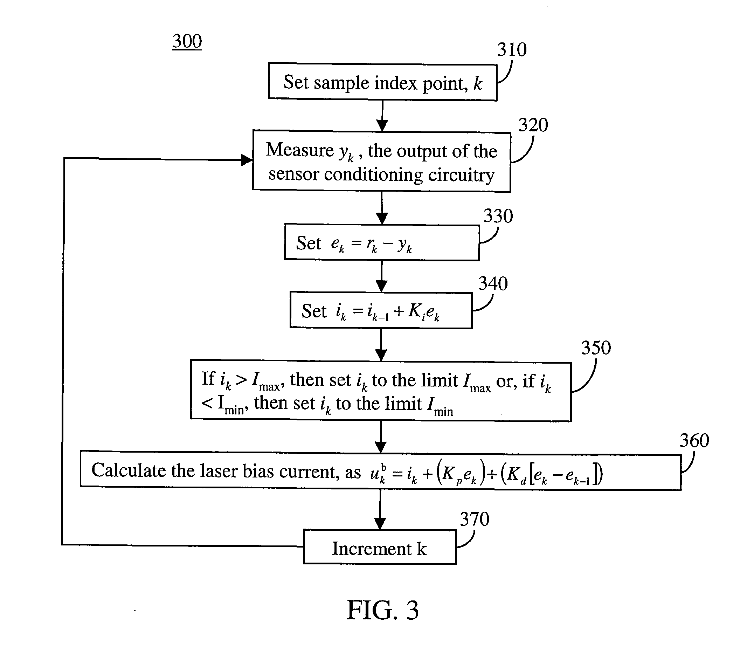

A second alternative method 300, in accordance with the present invention, of closed-loop control for maintaining constant average laser power is now described. The method 300 comprises an algorithm that is schematically illustrated in FIG. 3 and that is described in further detail in the following sentences. The mathematical symbols used in reference to the method 300 have the same meanings as previously described in reference to the method 200. In the first step 310 (FIG. 3) of the method 300 for closedloop control of the average laser power, the sample index $k$ is set. Next, the method 300 proceeds to step 320, wherein $y_k$, the output of the sensor-signal conditioning circuitry, is measured. Subsequently, the following steps are performed, in sequence (FIG. 3):

Step 330—Set $e_k = r_k - y_k$ wherein $e_k$ is the calculated error between the desired average power and the measured average power

Step 340—Set interim calculated current $i_k = i_{k-1} + K_i e_k$ wherein $K_i$ is the integral gain of the controller system

Step 350—If $i_k > I_{max}$, then set $i_k$ to the limit $I_{max}$ (maximum allowable limit) or, if $i_k < I_{min}$, then set $i_k$ to the limit $I_{min}$ (minimum allowable limit)

Step 360—Calculate the laser bias current, $u_k^b$, using the following expression

$$u_k^b = i_k + (K_p e_k) + (K_d[e_k - e_{k-1}])$$

In step 360, $K_p$ is the proportional gain of the controller system and $K_d$ is the derivative gain of the controller system. The method 300 proceeds from step 360 to step 370, in which the index variable $k$ is incremented. Finally, method 300 passes from step 370 back to step 320 and the sequence of steps 320-370 are iterated repeatedly as described above.

It may be observed that, except for the equation utilized in Step 4, the two-above described methods are identical. Depending on the type of laser being controlled, one of these algorithms may work better than the other in terms of response time and settling time. The laser bias current $u_k^b$ needs to be limited to stay within an acceptable minimum and maximum value. To minimize computational delay, preliminary calculations can be performed on the portion of $u_k^b$ that does not depend on the subsequent, $(k+1)th$, sample.

The targeted or desired laser power can be varied as a function of the laser temperature, and/or any other pertinent parameters, if needed. The variation of the targeted laser power can be implemented either as a table lookup or as an explicit equation of one or more variables. For example, a simple linear variation in laser power as a function of temperature is given by:

$$r_k = r_k^0 + c_1(T_k - T^0)$$

where $r_k^0$ is the targeted or desired average power without considering the temperature effect, and $T_k$ and $T^0$ are the current laser temperature (i.e., at the time of the $k^{th}$ sample) and the nominal laser temperature (e.g. room temperature) and $c_1$ is the slope of the average power versus temperature.

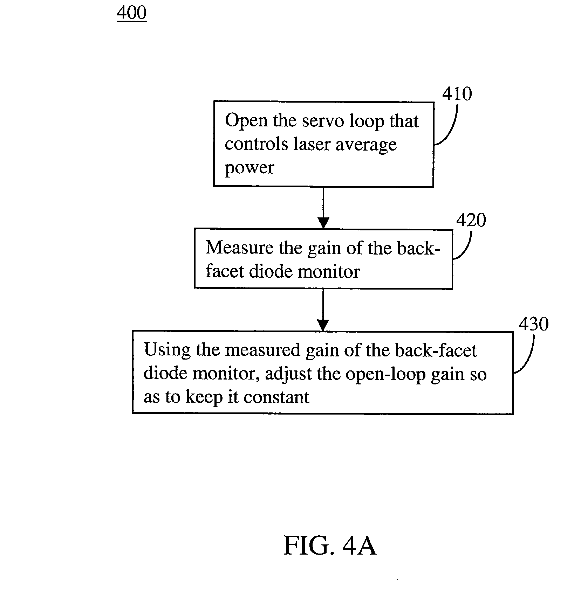

A third method 400, in accordance with the present invention, for controlling a laser source is now described with reference to FIGS. 4A-4B. The method 400 may be utilized to calibrate large variations (0.01 mA to 1.5 mA) of the back-facet diode current.

The method 400 comprises the following steps:

Step 410—Open the servo loop that controls the average laser power.

Step 420—Measure the gain of the back-facet diode monitor.

Step 430—Using the measured gain of the back-facet diode monitor, adjust the

open-loop gain so as to keep it constant.

Step 3 may be accomplished by multiplying the nominal loop gain by the following factor, $f$:

$$f = \frac{y_{nom}^2 - y_{nom}^1}{y_k^2 - y_k^1}$$

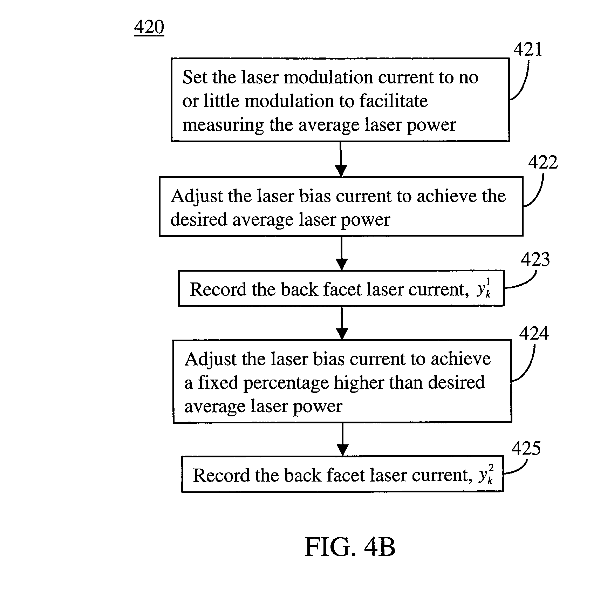

in which $y_{nom}^1$ and $y_{nom}^2$ are the nominal value, while the $y_k^2$ and $y_k^1$ represent the actual measured back facet laser current corresponding to the two applied laser bias current in open-loop mode. Further, as illustrated in FIG. 4B, Step 420 above may be comprised of the following set of sub-steps:

Sub-Step 421—Set the laser modulation current to no or little modulation to facilitate measuring the average laser power.
Sub-Step 422—Adjust the laser bias current to achieve the desired average laser power.

Sub-Step 423—Record the back facet laser current, $y_k^1$.
Sub-Step 424—Adjust the laser bias current to achieve a fixed percentage (e.g., 10%) higher than desired average laser power.
Sub-Step 425—Record the back facet laser current, $y_k^2$.

Due to the large variation in sensor gain (back facet diode's responsivity), a digital potentiometer can be controlled by the microprocessor (or micro controller) to deal with the large open-loop gain variation. The potentiometer's resistance is adjusted such that at the desired average laser power the back facet voltage is equal to a fixed value. The back facet voltage is the voltage across the digital potentiometer, thus it is equal to the potentiometer resistance times the back facet current.

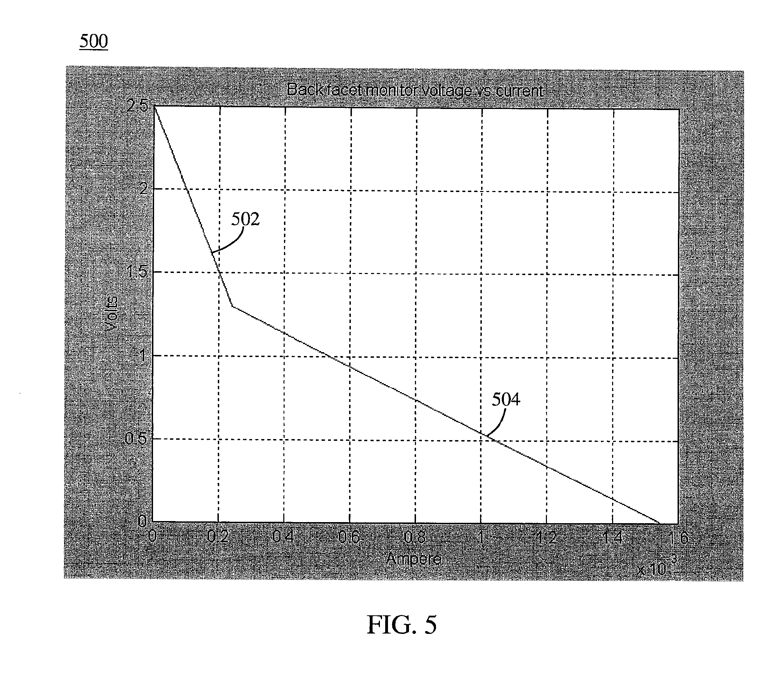

A simple gain switching circuit employing a shunt regulator (a.k.a. a zener diode) can also be used to deal with the large open-loop gain variation. For a back facet diode with low monitor current, the slope of the back facet monitor voltage vs. current is increased to provide a much wider range of the ADC value. By increasing the sensor output when the inherent signal is weak due to low responsivity, the servo system now has more range to work with. The amplification of the sensor measurements which has low inherent signal facilitates the stabilization and accuracy of the average laser power servo loop. FIG. 5 shows a graph 500 of the back facet monitor voltage vs. back facet diode current wherein the overall response consists of two portions, each portion having a respective slope of voltage vs. current. The first portion 502 has a much higher slope and is used with low back facet current for more signal amplification. The second portion 504 has a less steep slope for use with large back facet current. Similar effects can be achieved by using a non-linear transfer function instead of the piece-wise linear transfer function shown in FIG. 5.

The modulation DAC is adjusted from its nominal value as the laser bias DAC changes. The average target power can be kept constant or adjusted as a function of laser temperature. The adjustment of the modulation DAC as a function of the bias DAC is given by a relationship that can be determined empirically for a given laser diode type. The empirical data can be obtained by subjecting the laser diode to temperature variations and recording the corresponding laser modulation and bias DAC values. Note that the curve fit can be any order and thus not limited to the specific order. It has been demonstrated using the system described herein that a second or third order function is most likely adequate to yield good results. The concept of least-square fitting or table look up on these particular quantities is also applicable, and thus another variation of the same algorithm. An example of the adjustment is given by:

$$u_k^m = u_{nom}^m + a(u_k^b - u_{nom}^b) + b(u_k^b - u_{nom}^b)^2$$

where $u_k^m$ is the instantaneous modulation DAC output, $u_{nom}^m$ is the nominal steady state modulation DAC output at room temperature, $u_k^b$ is the instantaneous laser bias DAC output, $u_{nom}^b$ is the nominal steady state laser bias DAC at room temperature and $a$ and $b$ are empirically determined constants.

Use a look up table or a curve fit of initial laser bias current vs. temperature to speed up the laser power response and settling time. This is implemented in the firmware of the microprocessor. The initial bias DAC value to apply to the laser diode is looked up as a function of temperature. An example of this look up can be implemented in the firmware using a quadratic expression as follows:

$$u_{nom}^b + c(T_k - T^0) + d(T_k - T^0)^2$$

where $u_{nom}^b$, as defined previously, is the nominal steady state laser bias DAC output at room temperature, and $T_k$ and $T^0$ are the current laser temperature and the nominal laser temperature and c and d are the first-order and second-order coefficients of the initial laser bias current DAC vs temperature.

A novel and useful method and system for control of laser diodes in optical communications systems have been disclosed. Although the present invention has been disclosed in accordance with the embodiments shown, one of ordinary skill in the art will readily recognize that there could be variations to the embodiments and those variations would be within the spirit and scope of the present invention. Accordingly, many modifications could readily be envisioned by one of skill in the art without departing from the spirit and scope of the appended claims, which claims alone limit the invention.

**Claims**

1. A device for controlling a laser light source in an optical communication system, the device comprising:

   a multiplexer configured to receive at least one input data signal;
   at least one analog-to-digital converter electronically coupled to the multiplexer;
   a microprocessor electrically coupled to the at least one analog-to-digital converter, wherein the microprocessor is configured to maintain a constant average laser power by setting an index point, determining the difference between a desired average power and the at least one input signal, calculating a laser bias current and incrementing the sample index point;
   a first and a second digital-to-analog converter electrically coupled to the microprocessor for receiving digital signals from the microprocessor; and
   an optical transmitter module electrically coupled to the first and the second digital-to-analog converter, wherein the optical transmitter includes a laser diode that generates an information-bearing optical signal and a small sample proportion of the optical signal that is related to the at least one input data signal.

2. The device of claim 1, further comprising a back facet diode configured to receive the small sample proportion of the optical signal generated by the laser diode.

3. The device of claim 2, further comprising a sensor-signal conditioning circuitry coupled to the back-facet diode, wherein the sensor-signal conditioning circuitry receives an electrical signal from the back-facet diode and then generates the at least input data signal.

4. The device of claim 3, wherein the at least one data signal is an analog electrical signal whose voltage level is proportional to the power of the small sample proportion of the optical signal.

5. The device of claim 3, wherein the sensor-signal conditioning circuitry includes a potentiometer circuit to calibrate a large variation of a back-facet diode current.

6. The device of claim 5, wherein the large variation of a back-facet diode current is calibrated by opening a servo loop that controls an average laser power and then measuring a gain of a back facet diode monitor and subsequently using the measured gain of the back facet diode monitor to adjust an open-loop gain in order to maintain a constant open-loop gain.

7. The device of claim 3, wherein the sensor-signal conditioning circuitry includes a gain switching circuit to calibrate a large variation of a backfacet diode current.

8. The device of claim 1, wherein the first digital-to-analog converter delivers an analog signal for controlling a laser bias current.

9. The device of claim 1, wherein the second digital-to-analog converter delivers an analog signal for controlling a laser modulation current.

10. The device of claim 1, further comprising a temperature sensor coupled to the laser diode, wherein the temperature sensor generates a temperature analog signal proportional to a laser temperature, whereby the temperature analog signal is communicated to the multiplexer.

11. A method for controlling a laser light source in an optical communication system by maintaining constant average laser power, the method comprising:

    a) setting a sample index point relating to an average laser power;
    b) measuring an actual average laser power generated by a sensor conditioning circuitry in a controller system;
    c) calculating a difference between a desired average laser power and the actual average laser power;
    d) setting an interim calculated current relating to an integral gain of the controller system and the difference between a desired average laser power and the actua 1 average laser power
    e) calculating a laser bias current; and
    f) incrementing the sample index point.

12. The method of claim 11, further comprising resetting the interim calculated current by setting the interim calculated current to a maximum allowable limit if the interim calculated current is greater then the maximum allowable limit or by setting the interim calculated current to a minimum allowable limit if the interim calculated current is less then the minimum allowable limit.

13. The method of claim 11, wherein a previous laser bias current is used to calculate the laser bias current.

14. The method of claim 11, wherein the laser bias current relates to a proportional gain and a derivative gain of the controller system.

15. A method for controlling a laser light source in an optical communication system, the method comprising:

    opening a servo loop that controls an average laser power;
    measuring a gain of a back facet diode monitor; and
    adjusting an open-loop gain based on the measured gain of the back facet diode monitor such that the open-loop gain maintains a substantially constant value.

16. The method of claim 15, wherein measuring the gain of the back facet diode monitor includes setting a laser modulation current to little or no modulation to facilitate measuring of the average laser power.

17. The method of claim 16, wherein measuring the gain of the back facet diode monitor further includes adjusting a laser bias current to achieve a desired average laser power.

18. The method of claim 17, wherein measuring the gain of the back facet diode monitor further includes recording a back facet laser current.

19. The method of claim 18, wherein measuring the gain of the back facet diode monitor further includes adjusting the laser bias current to achieve a fixed percentage higher then the desired average laser power.

20. The method of claim 19, wherein the fixed percentage is 10% higher then the desired average laser power.

FIG. 1

200

Set sample index point, $k$ — 210

Measure $y_k$, the output of the sensor conditioning circuitry — 220

Set $e_k = r_k - y_k$ — 230

Set $i_k = i_{k-1} + K_i e_k$ — 240

If $i_k > I_{max}$, then set $i_k$ to the limit $I_{max}$ or, if $i_k < I_{min}$, then set $i_k$ to the limit $I_{min}$ — 250

Calculate the laser bias current, as $u_k^b = u_{k-1}^b + i_k + \left(K_p e_k\right) + \left(K_d \left[e_k - e_{k-1}\right]\right)$ — 260

Increment k — 270

FIG. 2

300

Set sample index point, $k$ — 310

Measure $y_k$, the output of the sensor conditioning circuitry — 320

Set $e_k = r_k - y_k$ — 330

Set $i_k = i_{k-1} + K_i e_k$ — 340

If $i_k > I_{max}$, then set $i_k$ to the limit $I_{max}$ or, if $i_k < I_{min}$, then set $i_k$ to the limit $I_{min}$ — 350

Calculate the laser bias current, as $u_k^b = i_k + (K_p e_k) + (K_d [e_k - e_{k-1}])$ — 360

Increment k — 370

FIG. 3

EP 1 594 238 A2

400

410

Open the servo loop that
controls laser average
power

420

Measure the gain of the back-
facet diode monitor

430

Using the measured gain of the back-facet
diode monitor, adjust the open-loop gain so
as to keep it constant

FIG. 4A

420

Set the laser modulation current to no or little modulation to facilitate measuring the average laser power — 421

Adjust the laser bias current to achieve the desired average laser power — 422

Record the back facet laser current, $y_k^1$ — 423

Adjust the laser bias current to achieve a fixed percentage higher than desired average laser power — 424

Record the back facet laser current, $y_k^2$ — 425

FIG. 4B

EP 1 594 238 A2

FIG. 5